# EUROPÄISCHE PATENTSCHRIFT

(11) **EP 3 645 452 B1**
(45) Veröffentlichungstag und Bekanntmachung des Hinweises auf die Patenterteilung: **02.10.2024**
(21) Anmeldenummer: 18731441.4
(22) Anmeldetag: 14.06.2018
(51) Int. Cl.: B81B 7/00, G01L 9/00

(54) **VERFAHREN ZUR HERSTELLUNG VON MIKROMECHANISCHEN MEMBRANSENSOREN**
METHOD FOR PRODUCING MICROMECHANICAL MEMBRANE SENSORS
PROCÉDÉ DE FABRICATION DE CAPTEURS À MEMBRANE MICROMÉCANIQUES

(30) Priorität: 26.06.2017 DE 102017210691
(43) Veröffentlichungstag der Anmeldung: 06.05.2020
(73) Patentinhaber: Robert Bosch GmbH, 70442 Stuttgart (DE)
(72) Erfinder: DANNENBERG, Arne, 72555 Metzingen (DE); OPPL, Stephan, 72793 Pfullingen (DE)
(86) Internationale Anmeldenummer: PCT/EP2018/065775
(87) Internationale Veröffentlichungsnummer: WO 2019/001974

(56) Entgegenhaltungen:
- EP-A2- 0 624 900
- DE-A1- 102004 043 356
- DE-A1- 102006 022 377
- DE-A1- 102008 002 579
- DE-A1- 102010 042 113

## Beschreibung

Die Erfindung betrifft ein Verfahren zur Herstellung von mikromechanischen Sensoren, insbesondere Druckdifferenzsensoren.

Die Erfindung betrifft ebenfalls einen mikromechanischen Sensor.

Obwohl die vorliegende Erfindung allgemein auf jegliche Art von mikromechanischen Sensoren anwendbar ist, wird die vorliegende Erfindung in Bezug auf mikromechanische Sensoren in Form von Druckdifferenzsensoren erläutert.

Mikromechanische Druckdifferenzsensoren umfassen üblicherweise Halbleiterwiderstände, die als mechanisch-elektrische Wandler verwendet werden. Diese nehmen nicht nur mechanische Belastungen auf, die sich durch den Druckeinfluss auf eine entsprechende Membran ergibt, sondern ebenfalls Belastungen durch mechanische Störeinflüsse. Hierbei treten mechanische Belastungen einerseits bei der Anbindung des Druckdifferenzsensors auf, beispielsweise durch Verformung einer Leiterplatte auf der der Druckdifferenzsensor angeordnet ist oder auch durch Kontaktierung mittels Löten, bei dem es zu einer Verformung der Schichtstruktur/ Package kommt, andererseits auch durch Belastungen aus dem Sensor selbst. Letztere können beispielsweise durch unterschiedliches Temperaturverhalten von verschiedenen Schichten der Schichtstruktur herrühren oder auch durch unterschiedliches Temperaturverhalten einer Metallisierung, insbesondere wenn großflächige Bondlands aufgebracht werden. Die oben beschriebenen Effekte sind außerdem abhängig von der Herstellungshistorie des Druckdifferenzsensors, also der Abfolge der Herstellungsschritte, was nur bedingt durch einen Abgleich vor Auslieferung des Druckdifferenzsensors kompensiert werden kann.

Ausgehend hiervon ist deshalb vorgeschlagen worden, Teile des Druckdifferenzsensors, also beispielsweise Membran und die entsprechenden mikromechanischen Drucksensoren, mechanisch vom Rest des Druckdifferenzsensors zu entkoppeln, beispielsweise durch ein im Wesentlichen allseitiges Freitrenchen der Membran des Drucksensors, also ein im Wesentlichen allseitiges Freiätzen der Membran bis auf einzelne Verbindungen, um elektrische Zuleitungen hierüber führen zu können. Der Drucksensor wird hierbei durch einen ganzflächigen Rückseiten-Trench freigestellt und der Rückseiten-Trench anschließend durch einen Waferbond mit einer Rückseitenkappe aufwendig wieder verschlossen. Eine zusätzliche Vorderseitenkappe mit Druckzugangslöchern schützt den freigestellten Drucksensor von oben. DE 10 2006 022377 A1 offenbart ein Verfahren zur Herstellung eines mikromechanischen Sensors. Hierbei wird auf ein Substrat eine Schicht aufgebracht, die im Bereich einer Kavität bzw. Kaverne eine Membran bildet. Die Kaverne wird von der Rückseite her in das Substrat eingebracht mittels eines Ätzverfahrens wie DRIE (Dry Reactive Ion Etch-Verfahren). Hierdurch wird die eigentliche Membran freigestellt. Von der Vorderseite der Membran her wird eine Struktur eingebracht, so dass Gräben gebildet werden, die im Bereich der Membran einen vertikalen Aufhängungsbereich der Membran entstehen lassen.

In einer Ausführungsform stellt die Erfindung ein Verfahren zur Herstellung eines mikromechanischen Sensors, insbesondere eines Druckdifferenzsensors, bereit, umfassend die Schritte
- Herstellen einer Funktionsschicht auf einem Substrat,
- Herstellen zumindest eines rückseitigen Trenchbereichs ausgehend von einer der Funktionsschicht abgewandten Rückseite des Substrats zur Freistellung der Funktionsschicht zur Bildung einer Sensormembran,
- Herstellen zumindest eines vorderseitigen Trenchbereichs zur Ausbildung zumindest einer Tragstruktur, insbesondere einer Energiespeicherstruktur, vorzugsweise in Form einer Federstruktur, im Substrat als Aufhängung für die Sensormembran, wobei der vorderseitige Trenchbereich mit dem rückseitigen Trenchbereich fluidisch verbunden ist, und
- Zumindest teilweises Verfüllen zumindest eines vorderseitigen Trenchbereichs mit einem Gel zur Abdichtung der Vorder- von der Rückseite.

In einer weiteren Ausführungsform stellt die Erfindung einen mikromechanischen Sensor bereit, hergestellt mit einem Verfahren gemäß einem der Ansprüche 1-10, insbesondere wobei der mikromechanische Sensor als Druckdifferenzsensor ausgebildet ist, wobei die Drucksensormembran eine Funktionsschicht und ein auf die Funktionsschicht aufgebrachtes Gel aufweist.

Mit anderen Worten wird durch Ausführungsformen der vorliegenden Erfindung eine allseitige Freistellung der Funktionsschicht ermöglicht, wobei eine teilweise Vergelung der durch die teilweise Freistellung entstandenen Lücken, Gräben und Spalte zur Abdichtung der Vorder- von der Rückseite erfolgt.

Einer der erzielten Vorteile ist, dass damit eine allseitige Freistellung einer Funktionsschicht, insbesondere zur Bildung einer Drucksensormembran, ermöglicht wird, so dass der Funktionsschichtbereich von Stress aus dem Package oder aus dem Aufbringungsort des Package entkoppelt ist. Darüber hinaus kann eine Vergelung auf Wafer-Level erfolgen und so eine günstigere Aufbau- und-Verbindungstechnik ermöglichen. Ein weiterer Vorteil ist, dass eine Stressentkopplung durch Verfüllen der klar definierten Trenchbereiche, beispielsweise Spalte, etc. in dem Substrat auf präzise Weise erfolgen kann. Dies vermindert die Streuung zwischen verschiedenen Sensoren, da hohe Kleberdicken, die schwer zu kontrollieren sind, nicht mehr notwendig sind.

Der Begriff "Trenchen" ist im weitesten Sinne zu verstehen und bezeichnet insbesondere das Herstellen von Gräben, Löchern, Spalten oder dergleichen durch Entfernen von Material aus einem Grundmaterial, beispielsweise durch Ätzen, insbesondere reaktives lonenätzen in Silizium.

Der Begriff "im Wesentlichen" oder "annähernd" ist im weitesten Sinne zu verstehen und bezieht sich insbesondere in den Ansprüchen, vorzugsweise in der Beschreibung auf Abweichungen, Variationen, Toleranzen, etc. in Bezug auf Abmessungen, Positionen, Abstände, Entfernungen, Bruchteile oder dergleichen. Beispielsweise bezeichnet der Ausdruck "eine Größe ist im Wesentlichen gleich einer zweiten Größe", dass die beiden Größen voneinander insbesondere um 100%, vorzugsweise um 75%, insbesondere um 50%, vorzugsweise um mindestens 25%, insbesondere um 20%, vorzugsweise um 10%, insbesondere zumindest 0,5%, vorzugsweise kleiner als 0,1%, insbesondere kleiner als 0,001% oder dergleichen voneinander abweichen können. Beispielsweise bezeichnet der Ausdruck "annährend isotroper Trench-Schritt", dass mehr als 50%, insbesondere mehr als 60%, vorzugsweise mehr als 70%, insbesondere mehr als 80%, vorzugsweise mehr als 90%, insbesondere mehr als 95% des Trenchens isotrop erfolgt.

Der Begriff "Gel" ist im weitesten Sinne zu verstehen und bezeichnet insbesondere ein disperses System, welches mindestens zwei Komponenten umfasst, insbesondere ein Polymernetzwerk und ein Lösungsmittel. Der Begriff "Gel" bezeichnet insbesondere eine weiche Masse und ein Gel entsteht, wenn das Polymernetzwerk das gesamte Lösungsmittel absorbiert hat. Insbesondere fällt unter den Begriff "Gel" sowohl bereits vernetztes als auch noch nicht vernetztes Gel. Beispiele für Gele sind Silikon Hydrogele, Hydrogele auf Basis von Polyacrylamid oder Polymacon (CAS-Nummer 25053-81-0), oder Hydrogele auf Basis quervernetzter Polymere, bspw. Poly(2-acrylamido-2-methyl-1-propansulfonsäure), Polyethylenglycol oder Polyvinylpyrrolidon.

Weitere Merkmale, Vorteile und weitere Ausführungsform der Erfindung sind im Folgenden beschrieben oder werden dadurch offenbar.

Gemäß einer vorteilhaften Weiterbildung werden mehrere rückseitige Trenchlöcher zum Herstellen des zumindest einen rückseitigen Trenchbereichs erzeugt. Einer der damit erzielten Vorteile ist, dass eine einfache Herstellung des zumindest einen rückseitigen Trenchbereichs ermöglicht wird.

Gemäß einer weiteren vorteilhaften Weiterbildung wird zumindest eine Kaverne zur Bildung eines ersten Verbindungstrenchbereichs zwischen rückseitigen Trenchlöchern erzeugt. Damit können auf eine Weise mehrere rückseitige Trenchlöcher fluidisch verbunden werden.

Gemäß einer weiteren vorteilhaften Weiterbildung werden mehrere vorderseitige Trenchgräben zum Herstellen des zumindest einen vorderseitigen Trenchbereichs erzeugt. Damit lässt sich auf einfache Weise zum Einen eine fast allseitige Freistellung der Funktionsschicht erreichen und zum Anderen beispielsweise eine Aufhängung für die Sensormembran herstellen.

Gemäß einer weiteren vorteilhaften Weiterbildung wird zwischen Substrat und Funktionsschicht eine Stoppschicht hergestellt, und der zumindest eine rückseitige Trenchbereich wird bis zu der Stoppschicht hergestellt, und die Stoppschicht anschließend im Bereich der Sensormembran entfernt. Mittels einer Stopschicht lassen sich bei einem zeitgesteuerten Herstellungsprozess die Prozessstreuungen senken.

Gemäß einer weiteren vorteilhaften Weiterbildung wird zumindest eine Kaverne zur Bildung zumindest eines zweiten Verbindungstrenchbereichs zwischen mehreren vorderseitigen Trenchbereichen erzeugt. Damit kann auf einfache Weise eine Fluidverbindung zwischen zwei vorderseitigen Trenchbereichen hergestellt werden, so dass sich die Energiespeicherstruktur, beispielsweise in Form einer langen Feder ausbildet, an dem der nahezu vollständig freigestellte Sensormembranbereich aufgehängt ist.

Gemäß einer weiteren vorteilhaften Weiterbildung wird ein Durchmesser der rückseitigen Trenchlöcher kleiner gewählt als der Durchmesser des Querschnitts zumindest einer Kaverne eines ersten und/oder eines zweiten Verbindungstrenchbereichs. Damit kann auf einfache Weise verhindert werden, dass das Gel durch die Rückseite des Substrats, beispielsweise zu einer Halterung eines Wafers fließt und diesen verschmutzt; das Gel kann dann insbesondere nur horizontal fließen.

Gemäß einer weiteren vorteilhaften Weiterbildung werden mehrere erste Verbindungstrenchbereiche hergestellt, die über zumindest einen Trenchkanal miteinander fluidisch verbunden sind und wobei zumindest einer der ersten Verbindungstrenchbereiche direkt unterhalb der Funktionsschicht zu deren Freistellung hergestellt wird. Auf diese Weise können einerseits kommunizierende Kavernen hergestellt werden, andererseits wird eine Verschmutzung der Unterseite der Funktionsschicht durch Partikel noch weiter reduziert.

Gemäß einer weiteren vorteilhaften Weiterbildung wird der zumindest eine vorderseitige Trenchbereich zeitlich vor dem zumindest einen rückseitigen Trenchbereich hergestellt. Einer der damit erzielten Vorteile ist, dass zunächst vollständig vorderseitige Trenchbereiche hergestellt werden und dann von der Rückseite die entsprechenden rückseitigen Trenchbereiche, was die Herstellung eines mikromechanischen Sensors insgesamt vereinfacht.

Gemäß einer weiteren vorteilhaften Weiterbildung ist der mikromechanische Sensor als Druckdifferenzsensor mit einer als Drucksensormembran ausgebildeten Funktionsschicht ausgebildet. Damit wird auf einfache und kostengünstige Weise ein Druckdifferenzsensor zur Verfügung gestellt.

Weitere wichtige Merkmale und Vorteile der Erfindung ergeben sich aus den Unteransprüchen, aus den Zeichnungen, und aus dazugehöriger Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungen und Ausführungsformen der Erfindung sind in den Zeichnungen dargestellt und werden in der nachfolgenden Beschreibung näher erläutert, wobei sich gleiche Bezugszeichen auf gleiche oder ähnliche oder funktional gleiche Bauteile oder Elemente beziehen.

Dabei zeigen in schematischer Form
- Fig. 1a-h: Schritte eines Verfahrens gemäß einer ersten Ausführungsform der vorliegenden Erfindung;
- Fig. 2a-f: Schritte eines Verfahrens gemäß einer zweiten Ausführungsform der vorliegenden Erfindung;
- Fig. 3a-d: Schritte eines Verfahrens gemäß einer dritten Ausführungsform der vorliegenden Erfindung;
- Fig. 4a-d: Schritte eines Verfahrens gemäß einer vierten Ausführungsform der vorliegenden Erfindung; und
- Fig. 5: eine Übersichtsdarstellung eines Druckdifferenzsensors hergestellt mit einem Verfahren gemäß einer Ausführungsform der vorliegenden Erfindung.

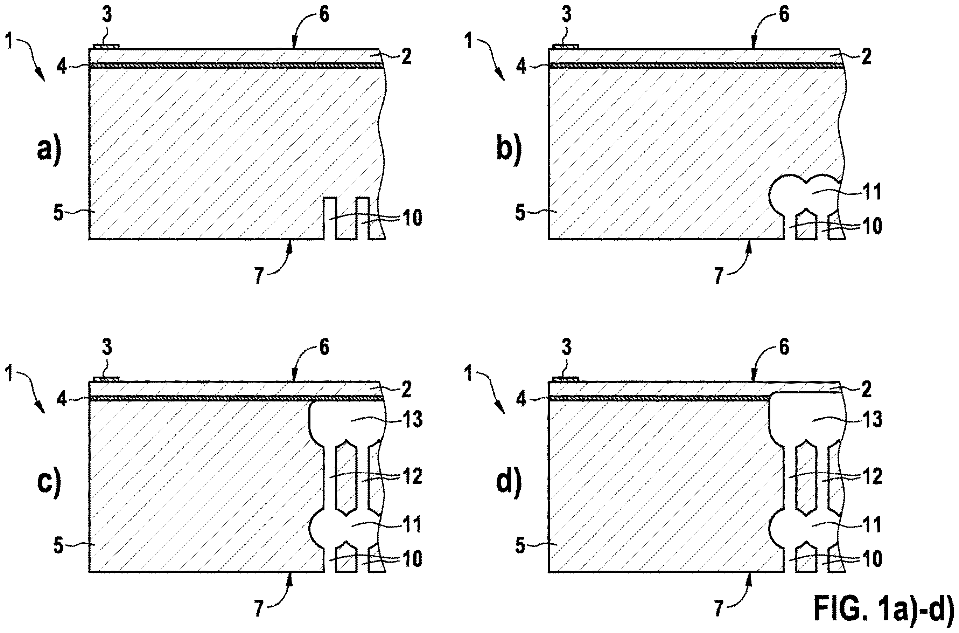

Fig. 1a-h zeigt Schritte eines Verfahrens gemäß einer ersten Ausführungsform der vorliegenden Erfindung zur Herstellung eines mikromechanischen Sensors 1 mit einer Membran, wobei der mikromechanische Sensor 1 dabei jeweils im Querschnitt dargestellt ist.

In einem ersten Schritt gemäß Fig. 1a werden in einem Wafer 5 mit einer im Bereich der Vorderseite des Wafers 5 eingebrachten Stoppschicht 4, z.B. ein Sol-Wafer sowie eventuell eindiffudierten piezoresistiven Widerständen (nicht dargestellt), Leiterbahnen (nicht dargestellt) und Bondpads 3 Trenchlöcher 10 mit hohem Aspektverhältnis, bspw. zwischen 5 und 100, auf der Rückseite 7 des Wafers 5 hergestellt, bspw. mittels Ätzen. Die Stoppschicht 4 kann dabei in bekannter Weise im Wafer hergestellt werden, beispielsweise mittels Abscheiden auf einem Substrat und Aufbringen einer sogenannten Sensor- oder Funktionsschicht 2 auf der abgeschiedenen Stoppschicht 4. Die Stoppschicht 4 kann dabei in bekannter Weise aus Siliziumoxid hergestellt sein.

In einem zweiten Schritt gemäß Fig. 1b wird ein isotroper oder annähernd isotroper Trench mit einem Aspektverhältnis zwischen 0,1 und 3 durchgeführt, so dass eine zusammenhängende Kaverne 11 entsteht. Die beiden Trenchlöcher 10 werden durch die Kaverne 11 fluidisch verbunden.

In einem dritten Schritt gemäß Fig. 1c werden die Trenchlöcher 10 in Richtung der Vorderseite 6 bzw. der Stoppschicht 4 über die Kaverne 11 hinaus verlängert und ein zweiter isotroper oder annähernd isotroper Trench mit einem Aspektverhältnis zwischen 0,1 und 3 durchgeführt, so dass unter der Stoppschicht 4 eine zweite Kaverne 13 entsteht, die mit der ersten Kaverne 11 fluidisch kommuniziert bzw. verbunden ist.

In einem vierten Schritt gemäß Fig. 1d wird die Stoppschicht 4 im Bereich der zweiten Kaverne 13 entfernt, um Einflüsse dieser Schicht 4 auf das mechanische Verhalten der freigestellten und oberhalb der Stoppschicht 4 angeordneten Funktionsschicht 2 zu vermeiden.

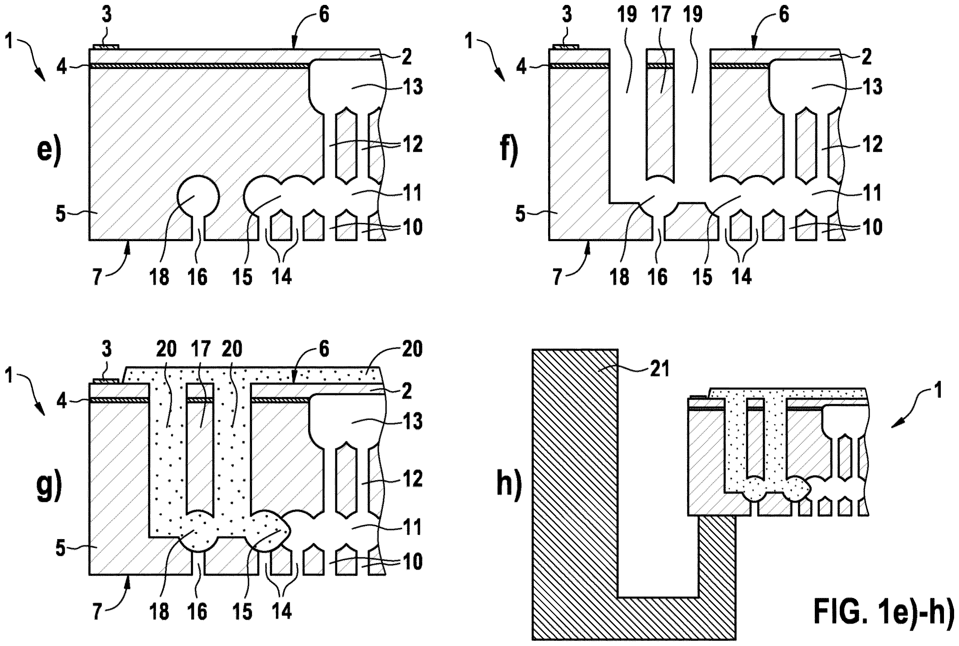

In einem fünften Schritt gemäß Fig. 1e) wird ein dritter isotroper oder annähernd isotroper Trench durchgeführt, wobei hierzu nicht miteinander kommunizierende Kavernen 15, 16 oder miteinander kommunizierende Kavernen, letztere sind in Fig. 1e nicht dargestellt, hergestellt werden. Hierfür können die rückseitigen Trenchlöcher 10, die Kavernen 11 und 13 sowie die Verbindungskanäle 12, hergestellt im zweiten und dritten Schritt abgedeckt werden, z. B. mit einem Trockenresist, um deren Beschädigung, bspw. beim Ätzen im fünften Schritt zu vermeiden.

In einem sechsten Schritt gemäß Fig. 1f) wird mittels Trenchen 19 von der Vorderseite 6 eine Federstruktur 17 und damit die Funktionsschicht 2, insbesondere der Drucksensormembranbereich, auch seitlich frei gestellt, in Fig. 1f auf der linken Seite. Eine Stressentkopplung ist nun gewährleistet, Vorder- und Rückseite 6, 7 sind aber noch fluidisch verbunden, so dass damit kein Differenzdruck zwischen Vorder- und Rückseite des Sensors 1 gemessen werden kann.

In einem siebten Schritt gemäß Fig. 1g) wird die fluidische Verbindung von Vorderseite 6 zu Rückseite 7 unterbrochen, indem ein flüssiges oder gelartiges Material 20 in die Zwischenräume 19, 18, 15 eingefüllt und auf die Funktionsschicht 2 aufgebracht wird. Die Drucksensormembran wird somit durch die freigestellte Funktionsschicht 2 und dem auf dieser Schicht 2 aufgebrachten Gel 20 gebildet Vorzugsweise ist das Gel 20 zunächst ein im Wesentlichen flüssiges Material, was nach einem Aushärtungs- bzw. Vernetzungsschritt gelartig, d. h. weich und nicht plastisch verformbar, wird. Je weicher dieses ausgebildet wird, desto besser erfolgt die Stressenkopplung des Drucksensormembranbereiches vom Package. Ein noch nicht quervernetztes Gel kann beispielsweise über ein Siebdruckverfahren auf die Oberfläche des Wafers 5 aufgetragen werden, ohne dass z. B. Bondpad-Bereiche 3 verunreinigt werden. Bei geeignetem Druck fließt das Gel 20 insbesondere in die Zwischenräume 15, 18, 19, wobei durch die Rückseiten-Trench-Zugangslöcher 10, 14, 16 Luft entweichen kann. Sind die Durchmesser der Zugangslöcher 10, 14, 16 kleiner als der Querschnitt der Kavernen 11, 15, 18, wird das Gel 20 horizontal in Richtung der ersten Kaverne 11 fließen statt durch die Rückseite 7, also in und durch die Trenchlöcher 10, 14, 16, sodass das Gel 20 z. B. die Halterung für den Wafer 5 zu verschmutzen könnte. Bei geeigneter horizontaler Fließweglänge vom unteren Bereich des Vorderseiten-Trench 18 zur ersten Kaverne 11 ist dabei eine Prozesssicherheit des Gel-Verfüllschrittes gegeben. Es kann sogar ein Teil der ersten Kaverne 11 mit Gel 20 verfüllt werden, ohne die Sensorperformance signifikant zu beeinflussen. Ein Verfüllen der ersten Kaverne 11 sollte jedoch vermieden werden, da so die zweite Kaverne 13 verschlossen wird und der Membran 2 nicht mehr rückseitig mit Druck beaufschlagbar ist.

In einem achten Schritt gemäß Fig. 1h) wird der mikromechanische Sensor 1 in der Aufbau-und-Verbindungstechnik so verklebt, dass Vorderseiten- und Rückseitendruck angeschlossen werden können.

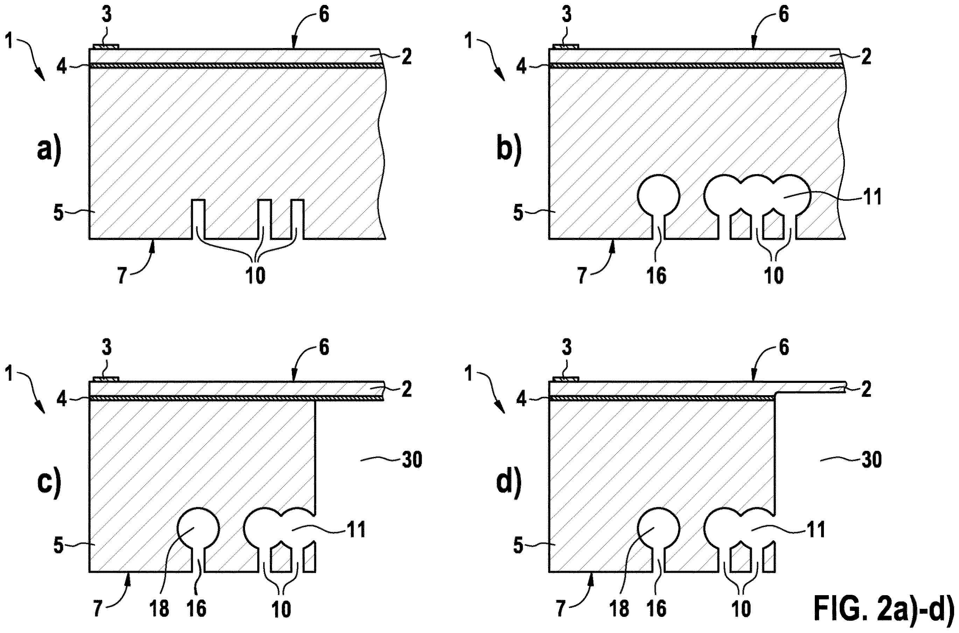

Fig. 2a-f zeigen Schritte eines Verfahrens gemäß einer zweiten Ausführungsform der vorliegenden Erfindung.

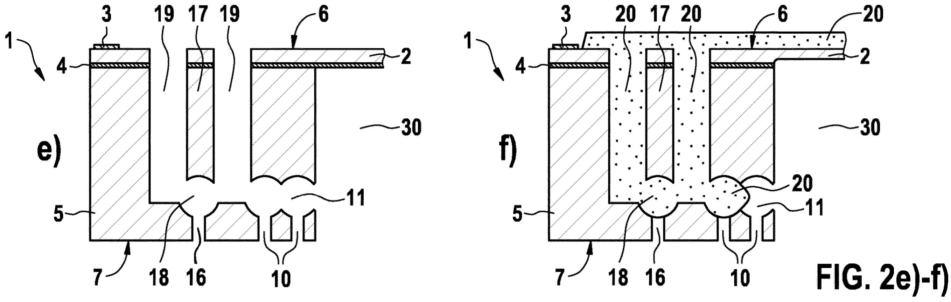

In Fig. 2 ist eine zweite Ausführungsform der Erfindung zur Herstellung eines Differenzdrucksensors mit nur einem isotropen oder annähernd isotropen Trench mit einem Aspektverhältnis zwischen 0,1 und 3 und ohne Gitterstruktur unter der Drucksensormembran gezeigt.

In einem ersten Schritt gemäß Fig. 2a werden wie in Schritt 1 der Fig. 1a mehrere rückseitige Trenchlöcher 10, 16 mit hohem Aspektverhältnis, bspw. zwischen 5 und 100, erzeugt.

In einem zweiten Schritt gemäß Fig. 2b werden dann über diese von der Rückseite 7 des Wafers 5 mittels eines isotropen oder annähernd isotropen Trench, Kavernen 11, 18 erzeugt, wobei eine der Kavernen 11 mehrere Trenchlöcher 10 fluidisch verbindet.

In einem dritten Schritt gemäß Fig. 2c wird eine Kavität 30 bis zur Stoppschicht 4, z. B. Siliziumoxid eines SOI-Wafers erzeugt, bspw. durch anisotropes Ätzen, so dass die Drucksensormembran 2 definiert, d.h. im Wesentlichen unterhalb dieser freigestellt wird. Hierbei können die Zugangslöcher bzw. rückseitigen Trenchlöcher 10 zur Kaverne 11 beispielsweise durch Trockenresist maskiert werden. Die Kavität 30 zur Stoppschicht 4 überlappt dabei mit der Kaverne 11, sodass später ein freigestellter Drucksensormembranbereich entsteht.

In einem vierten Schritt gemäß Fig. 2d wird die Stoppschicht 4 unter der Funktionsschicht 2 entfernt, um Einflüsse der Stoppschicht 4 auf das mechanische Verhalten der späteren Drucksensormembran zu vermeiden.

In einem fünften Schritt gemäß Fig. 2e wird der Drucksensormembranbereich mittels vorderseitigen Trenchgräben 19 freigestellt derart, dass die Kaverne 18 die vorderseitigen Trenchgräben 19 fluidisch verbindet und ebenfalls eine fluidische Verbindung zwischen den Kavernen 11, 18 hergestellt wird.

In einem sechsten Schritt gemäß Fig. 2f werden die Zwischenräume analog zu dem achten Schritt gemäß Fig. 1h mit Gel 20 verfüllt bzw. Gel 20 auf die Funktionsschicht 2 aufgebracht, das anschließend aushärtet oder vernetzt wird. Die Drucksensormembran wird somit wieder durch die freigestellte Funktionsschicht 2 und dem auf dieser Funktionsschicht 2 aufgebrachten Gel 20 gebildet.

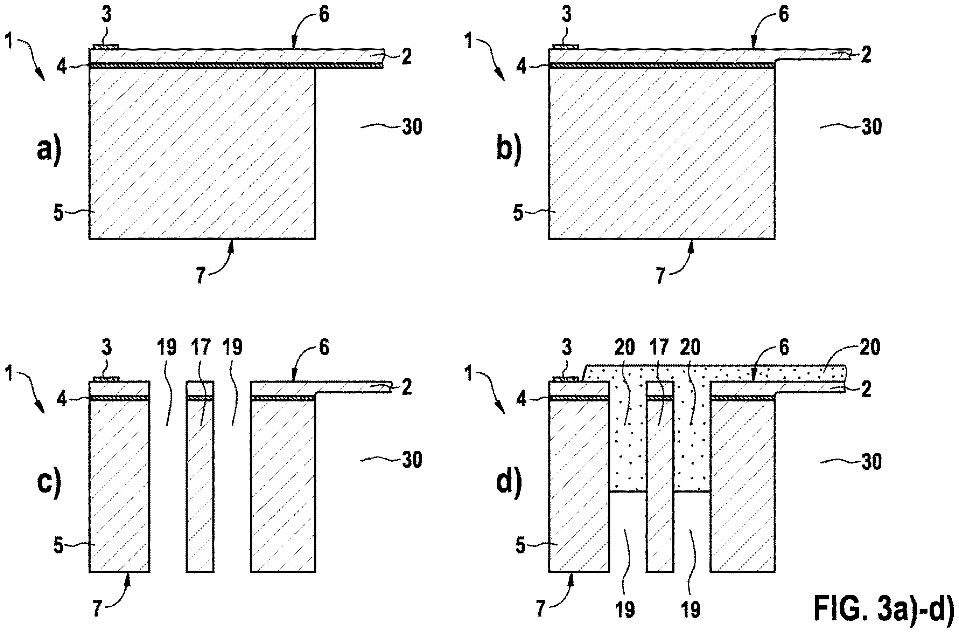

Fig. 3a-d zeigen Schritte eines Verfahrens gemäß einer dritten Ausführungsform der vorliegenden Erfindung.

In Fig. 3 ist ein Prozessablauf für die Herstellung eines Differenzdrucksensors ohne isotropen oder annähernd isotropen Trench-Schritt, ohne eine Gitterstruktur unter der Drucksensormembran und ohne Auffangbereich für das Gel 20 gezeigt.

Der erste Schritt gemäß Fig. 3a entspricht im Wesentlichen dem ersten Schritt gemäß Fig. 1a. Im Unterschied zum ersten Schritt gemäß Fig. 1a werden beim ersten Schritt gemäß Fig. 3a keine rückseitigen Trenchlöcher 10 erzeugt, dafür jedoch wird bis zur Stoppschicht 4 getrencht und so eine Drucksensormembran definiert.

In einem zweiten Schritt gemäß Fig. 3b wird die Stoppschicht 4 entfernt.

In einem dritten Schritt gemäß Fig. 3c wird von der Vorderseite 6 durch den kompletten Wafer 5 getrencht, es entstehen Spalte 19, wobei zwischendurch die Stoppschicht 4 entfernt wird.

In einem vierten Schritt gemäß Fig. 3d werden diese wieder mit Gel 20 verfüllt und Gel 20 auf die Oberseite der Funktionsschicht 2 aufgebracht, im Wesentlichen analog zum siebten Schritt gemäß Fig. 1g. Die Drucksensormembran 2, 20 wird somit wieder durch den freigestellten Bereich der Funktionsschicht 2 und dem auf dieser Schicht 2 aufgebrachten Gel 20 gebildet.

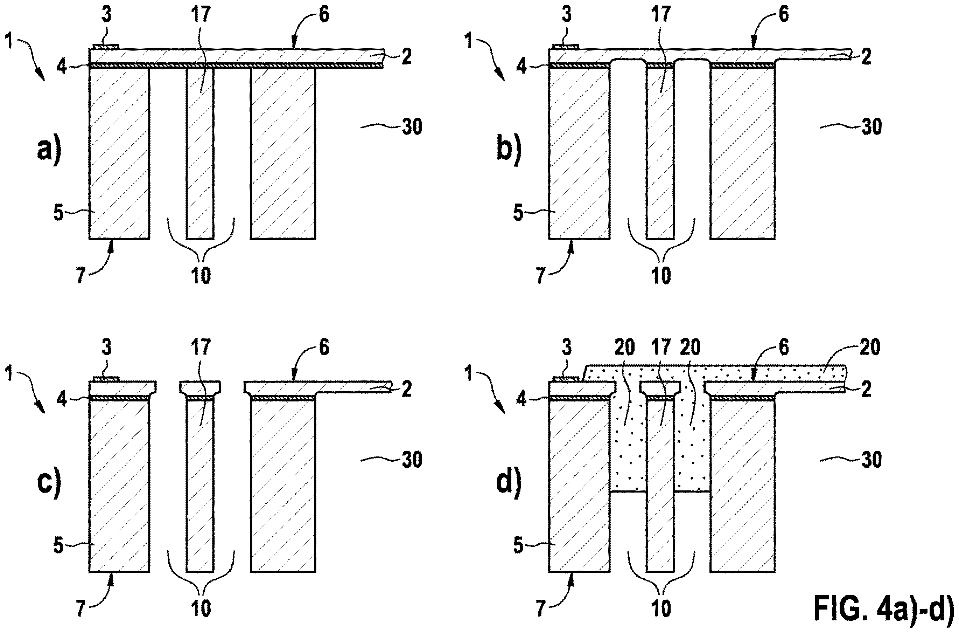

Figur 4a-d zeigt Schritte eines Verfahrens gemäß einer vierten Ausführungsform der vorliegenden Erfindung.

In Fig. 4 ist ein Prozessablauf zur Herstellung eines Druckdifferenzsensors gemäß einer vierten Ausführungsvariante der Erfindung ohne isotropen oder annähernd isotropen Trench-Schritt, ohne Gitterstruktur unter der Drucksensormembran und ohne Gel-Auffangbereich gezeigt.

In einem ersten Schritt gemäß Figur 4a werden rückseitig sowohl Trenchgräben 10 als auch ein Trench 30 zur Freistellung des Drucksensormembranbereichs bis zur Stoppschicht 4 durchgeführt.

In einem zweiten Schritt gemäß Figur 4b wird in den beiden rückseitigen Trenchgräben 10 und dem Trench 30 jeweils die Stoppschicht 4 entfernt.

In einem dritten Schritt gemäß Figur 4c werden nun entsprechend von vorne die beiden rückseitigen Trenchgräben 10 geöffnet, wobei die Stoppschicht 4 nicht mehr entfernt werden muss.

In einem vierten Schritt gemäß Figur 4d erfolgt nun ein Verfüllen der Trenchgräben 10 derart, dass das Gel 20 in die rückseitigen Trenchgräben 10 nur teilweise fließt. Mit anderen Worten wird in der Ausführungsform der Figur 4 ein Teil der Entkopplungszwischenräume zur Freistellung der Federstruktur 17 während dem Schritt des Definierens der Drucksensormembran mittels Trench 30 angelegt. Dies hat unter Anderem den Vorteil, dass die Ätzzeit verkürzt wird, weil ein Ätzumgriff von der Vorderseite 6 zur Rückseite 7 der Funktionsschicht 2 aufgrund des größeren Diffusionswegs und der geringeren Streuung der Ätzzeit nach lokalem Öffnen der Vorderseite 6 zur Rückseite 7 reduziert wird.

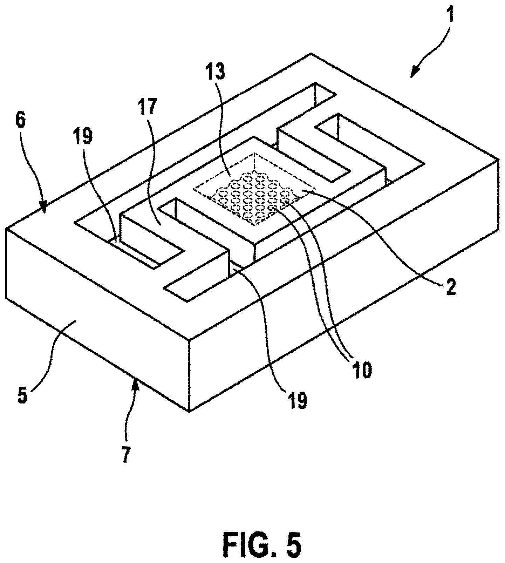

Fig. 5 zeigt eine Übersichtsdarstellung eines Druckdifferenzsensors hergestellt mit einem Verfahren gemäß einer Ausführungsform der vorliegenden Erfindung.

In Fig. 5 ist ein Druckdifferenzsensor nach Durchführen der Schritte a)-f) gemäß Fig. 1 gezeigt. Fig. 1 zeigt dabei einen Querschnitt von der linken Seite des Substrats 5 bis zur Mitte der Drucksensormembran dar. Hierbei ist die Funktionsschicht 2 nur angedeutet, die Gelverfüllung ist nicht gezeigt. Zu sehen sind die rückseitigen Trenchlöcher 14 und der unter der Funktionsschicht 2 freigestellte Bereich bzw. Kaverne 13. Die rückseitigen Trenchlöcher 16 unterhalb der freigestellten federartigen Struktur 17 sind in der Fig. 5 nicht dargestellt. Die federartige Struktur 17 ist hier ausgehend von zwei der vier Ränder des Substrats 5 im Wesentlichen S-förmig ausgebildet.

In allen Ausführungsformen können die als Balkenfedern 17 gezeigten Strukturen auch als mäandrierte Federn, Federn mit Winkeln oder Federn mit beliebigen Kurvenformen ausgebildet bzw. abgetrennt werden. Hierbei können beliebig viele Federn zur Kontaktierung des Bereichs der Drucksensormembran ausgebildet werden. Die Federn können sich hierbei vereinigen und/oder aufspalten und dienen zur Aufhängung und ggf. Kontaktierung von Sensoren im Bereich der Drucksensormembran

Zusammenfassend weist zumindest eine Ausführungsform zumindest einen der folgenden Vorteile auf oder ermöglicht einen dieser Vorteile:
- Vermeidung von Stress aus dem Package
- Vermeidung von Stress aus dem Aufbewahrungsort des Package
- günstigere Aufbau-und-Verbindungs-Technik
- Vergelung auf Wafer Level möglich, beispielsweise mittels Siebdruck
- kontrolliertes Verfüllen durch die klar definierten Trenchgräben/löcher.

Obwohl die vorliegende Erfindung anhand bevorzugter Ausführungsbeispiele beschrieben wurde, ist sie nicht darauf beschränkt, sondern auf vielfältige Weise modifizierbar.

## Patentansprüche

1. Verfahren zur Herstellung eines mikromechanischen Sensors, insbesondere eines Druckdifferenzsensors, umfassend die Schritte
- Herstellen einer Funktionsschicht (2) auf einem Substrat (5),
- Herstellen zumindest eines rückseitigen Trenchbereichs (10, 11, 12, 13, 30) ausgehend von einer der Funktionsschicht (2) abgewandten Rückseite (7) des Substrats (5) zur Freistellung der Funktionsschicht (2) zur Bildung einer Sensormembran (2, 20),
- Herstellen zumindest eines vorderseitigen Trenchbereichs (19) zur Ausbildung zumindest einer Tragstruktur (17), insbesondere einer Energiespeicherstruktur, vorzugsweise in Form einer Federstruktur, im Substrat (5) als Aufhängung für die Sensormembran (2, 20), wobei der vorderseitige Trenchbereich mit dem rückseitigen Trenchbereich fluidisch verbunden ist, und
- Zumindest teilweises Verfüllen zumindest eines vorderseitigen Trenchbereichs (19) mit einem Gel (20) zur Abdichtung der Vorder- von der Rückseite.

2. Verfahren gemäß Anspruch 1, wobei mehrere rückseitige Trenchlöcher zum Herstellen des zumindest einen rückseitigen Trenchbereichs (10, 11, 12, 13, 30) erzeugt werden.

3. Verfahren gemäß Anspruch 2, wobei zumindest eine Kaverne (11, 13, 15) zur Bildung eines ersten Verbindungstrenchbereichs zwischen rückseitigen Trenchlöchern (10) erzeugt wird.

4. Verfahren gemäß einem der Ansprüche 1-3, wobei mehrere vorderseitige Trenchgräben zum Herstellen des zumindest einen vorderseitigen Trenchbereichs (19) erzeugt werden.

5. Verfahren gemäß einem der Ansprüche 1-4, wobei
- zwischen Substrat (5) und Funktionsschicht (2) eine Stoppschicht (4) hergestellt wird, und wobei
- der zumindest eine rückseitige Trenchbereich (10, 11, 12, 13, 30) bis zu der Stoppschicht (4) hergestellt wird, und wobei
- die Stoppschicht (4) anschließend im Bereich der Sensormembran (2, 20) entfernt wird.

6. Verfahren gemäß einem der Ansprüche 1-5, wobei zumindest eine Kaverne zur Bildung zumindest eines zweiten Verbindungstrenchbereichs (18) zwischen mehreren vorderseitigen Trenchbereichen (19) erzeugt wird.

7. Verfahren gemäß Anspruch 2, wobei ein Durchmesser der rückseitigen Trenchlöcher (10) kleiner gewählt wird als der Durchmesser des Querschnitts zumindest einer Kaverne (11, 13, 15) eines ersten (11, 13, 15) und/oder eines zweiten Verbindungstrenchbereichs (18).

8. Verfahren gemäß Anspruch 3, wobei mehrere erste Verbindungstrenchbereiche (11, 13) hergestellt werden, die über zumindest einen Trenchkanal (12) miteinander fluidisch verbunden sind und wobei zumindest einer der ersten Verbindungstrenchbereiche (13) direkt unterhalb der Funktionsschicht (2) zu deren Freistellung hergestellt wird.

9. Verfahren gemäß einem der Ansprüche 1-8, wobei der zumindest eine vorderseitige Trenchbereich (19) zeitlich vor dem zumindest einen rückseitigen Trenchbereich (10, 11, 12, 13, 30) hergestellt wird.

10. Verfahren gemäß einem der Ansprüche 1-9, wobei ein oder mehrere Zugangskanäle (10, 12, 14, 16) zu den ersten und/oder zweiten Verbindungstrenchbereichen (11, 13, 15, 18) während der Freistellung der Funktionsschicht (2) mas¬kiert werden.

11. Mikromechanischer Sensor, hergestellt mit einem Verfahren gemäß einem der Ansprüche 1-10, insbesondere wobei der mikromechanische Sensor als Druckdifferenzsensor ausgebildet ist, wobei die Drucksensormembran eine Funktionsschicht (2) und ein auf die Funktionsschicht (2) aufgebrachtes Gel (20) aufweist.

## Claims

1. Method for producing a micromechanical sensor, in particular a pressure difference sensor, comprising the steps:
- producing a functional layer (2) on a substrate (5),
- producing at least one rear-side trench region (10, 11, 12, 13, 30) proceeding from a rear side (7) of the substrate (5), said rear side facing away from the functional layer (2), in order to free the functional layer (2) in order to form a sensor membrane (2, 20),
- producing at least one front-side trench region (19) in order to form at least one carrying structure (17), in particular an energy storage structure, preferably in the form of a spring structure, in the substrate (5) as suspension for the sensor membrane (2, 20), wherein the front-side trench region is fluidically connected to the rear-side trench region, and
- at least partly filling at least one front-side trench region (19) with a gel (20) in order to seal the front side from the rear side.

2. Method according to Claim 1, wherein a plurality of rear-side trench holes are generated in order to produce the at least one rear-side trench region (10, 11, 12, 13, 30).

3. Method according to Claim 2, wherein at least one cavity (11, 13, 15) is generated in order to form a first connecting trench region between rear-side trench holes (10).

4. Method according to any of Claims 1-3, wherein a plurality of front-side trench grooves are generated in order to produce the at least one front-side trench region (19).

5. Method according to any of Claims 1-4, wherein
- a stop layer (4) is produced between substrate (5) and functional layer (2), and wherein
- the at least one rear-side trench region (10, 11, 12, 13, 30) is produced as far as the stop layer (4), and wherein
- the stop layer (4) is subsequently removed in the region of the sensor membrane (2, 20).

6. Method according to any of Claims 1-5, wherein at least one cavity is generated in order to form at least one second connecting trench region (18) between a plurality of front-side trench regions (19).

7. Method according to Claim 2, wherein a diameter of the rear-side trench holes (10) is chosen to be smaller than the diameter of the cross section of at least one cavity (11, 13, 15) of a first connecting trench region (11, 13, 15) and/or of a second connecting trench region (18).

8. Method according to Claim 3, wherein a plurality of first connecting trench regions (11, 13) are produced, which are fluidically connected to one another via at least one trench channel (12), and wherein at least one of the first connecting trench regions (13) is produced directly below the functional layer (2) in order to free the latter.

9. Method according to any of Claims 1-8, wherein the at least one front-side trench region (19) is produced at a time before the at least one rear-side trench region (10, 11, 12, 13, 30).

10. Method according to any of Claims 1-9, wherein one or more access channels (10, 12, 14, 16) to the first and/or second connecting trench regions (11, 13, 15, 18) are masked during the freeing of the functional layer (2).

11. Micromechanical sensor, produced by a method according to any of Claims 1-10, in particular wherein the micromechanical sensor is designed as a pressure difference sensor, wherein the pressure sensor membrane comprises a functional layer (2) and a gel (20) applied to the functional layer (2).

## Revendications

1. Procédé de fabrication d'un capteur micromécanique, notamment d'un capteur de différence de pression, comprenant les étapes suivantes
- fabrication d'une couche fonctionnelle (2) sur un substrat (5),
- fabrication d'au moins une zone de tranchée (en allemand *"Trenchbereich")* arrière (10, 11, 12, 13, 30) en partant d'une face arrière (7) du substrat (5) opposée à la couche fonctionnelle (2) de façon à exposer la couche fonctionnelle (2) afin de former une membrane de capteur (2, 20),
- fabrication d'au moins une zone (19) de tranchée avant pour former au moins une structure porteuse (17), en particulier une structure d'accumulation d'énergie, de préférence sous la forme d'une structure à ressort, dans le substrat (5) en tant que suspension pour la membrane de capteur (2, 20), la zone de tranchée avant étant fluidiquement reliée à la zone de tranchée arrière, et
- remplissage au moins partiel d'au moins une zone de tranchée côté avant (19) avec un gel (20) pour assurer l'étanchéité entre le côté avant et le côté arrière.

2. Procédé selon la revendication 1, dans lequel plusieurs trous de tranchée arrière sont créés pour réaliser ladite au moins une zone (10, 11, 12, 13, 30) de tranchée arrière.

3. Procédé selon la revendication 2, dans lequel au moins une caverne (11, 13, 15) est générée pour former une première zone de tranchée de connexion entre des trous de tranchée arrière (10).

4. Procédé selon l'une des revendications 1 à 3, dans lequel il est créé une pluralité de tranchées avant pour former ladite au moins une zone (19) de tranchée avant.

5. Procédé selon l'une des revendications 1 à 4, dans lequel
- une couche d'arrêt (4) est fabriquée entre le substrat (5) et la couche fonctionnelle (2), et dans lequel
- ladite au moins une zone (10, 11, 12, 13, 30) de tranchée arrière est fabriquée jusqu'à la couche d'arrêt (4), et dans lequel
- la couche d'arrêt (4) est ensuite retirée dans la zone de la membrane de capteur (2, 20).

6. Procédé selon l'une des revendications 1 à 5, dans lequel au moins une caverne est créée pour former au moins une deuxième zone (18) de tranchée de connexion entre plusieurs zones (19) de tranchée avant.

7. Procédé selon la revendication 2, dans lequel un diamètre des trous (10) de tranchée arrière est choisi de façon à être inférieur au diamètre de la section transversale d'au moins une caverne (11, 13, 15) d'une première (11, 13, 15) et/ou d'une deuxième zone (18) de tranchée de connexion.

8. Procédé selon la revendication 3, dans lequel on réalise plusieurs premières zones de tranchées de liaison (11, 13) qui sont reliées fluidiquement entre elles par au moins un canal de tranchée (12) et dans lequel au moins une des premières zones (13) de tranchées de liaison est réalisée directement en dessous de la couche fonctionnelle (2) de façon à l'exposer.

9. Procédé selon l'une des revendications 1 à 8, dans lequel ladite au moins une zone (19) de tranchée avant est, temporellement, réalisée avant ladite au moins une zone (10, 11, 12, 13, 30) de tranchée arrière.

10. Procédé selon l'une des revendications 1 à 9, dans lequel un ou plusieurs canaux d'accès (10, 12, 14, 16) à la première et/ou à la deuxième zone (11, 13, 15, 18) de tranchée de liaison sont masqués pendant le dégagement de la couche fonctionnelle (2).

11. Capteur micromécanique fabriqué par un procédé selon l'une des revendications 1 à 10, en particulier dans lequel le capteur micromécanique est conçu sous la forme d'un capteur de différence de pression, la membrane du capteur de pression présentant une couche fonctionnelle (2) et un gel (20) appliqué sur la couche fonctionnelle (2).
